(19) Europäisches Patentamt

European Patent Office

Office européen des brevets

(11) **EP 0 982 763 A1**

(12) **EUROPEAN PATENT APPLICATION**

(43) Date of publication:
**01.03.2000 Bulletin 2000/09**

(51) Int. Cl.[7]: **H01L 21/205**

(21) Application number: **99115133.3**

(22) Date of filing: **06.07.1992**

(84) Designated Contracting States:
**DE FR GB**

(30) Priority: **05.07.1991 JP 19088391**

(62) Document number(s) of the earlier application(s) in accordance with Art. 76 EPC:
**92914380.8 / 0 548 368**

(71) Applicant:
**MITSUBISHI KASEI CORPORATION**
**Tokyo 100 (JP)**

(72) Inventor:
**The designation of the inventor has not yet been filed**

(74) Representative:
**VOSSIUS & PARTNER**
**Siebertstrasse 4**
**81675 München (DE)**

Remarks:
This application was filed on 11 - 08 - 1999 as a divisional application to the application mentioned under INID code 62.

(54) **MOVPE growth of III-V compound semiconductor layers**

(57) A vapor phase growth process for the fabrication of a thin film form of compound semiconductor of elements of Groups III-V, using a halogen element-free hydride and a halogen element-free organic metal as the source materials for growth, is characterized in that a halide gas and/or a halogen gas that are free from the mother elements of the compound to be grown are added to the reaction atmosphere while the compound is growing. A trace amount(s) of the halide and/or halogen gas(es) that are free from the mother elements of the compound to be grown, such as HCl, is added to the reaction atmosphere while the compound is growing, thereby making it possible to flatten the heterojunction interface or effect the growth of high-quality crystals without deposition of polycrystals on a mask over a wide range.

FIG. 1

| | |
|---|---|
| $Al_{0.3}Ga_{0.7}$ As Barrier Layer 1000Å | GaAs Cap Layer 50Å |
| $Al_{0.3}Ga_{0.7}$ As Barrier Layer 500Å | GaAs Quantum Well Layer 10Å |
| $Al_{0.3}Ga_{0.7}$ As Barrier Layer 500Å | " 20Å |
| $Al_{0.3}Ga_{0.7}$ As Barrier Layer 500Å | " 30Å |
| $Al_{0.3}Ga_{0.7}$ As Barrier Layer 500Å | " 60Å |
| $Al_{0.3}Ga_{0.7}$ As Barrier Layer 500Å | " 80Å |
| $Al_{0.3}Ga_{0.7}$ As Barrier Layer 1000Å | " 100Å |
| Ga As Buffer Layer 2000Å | |
| Ga As Substrate | |

EP 0 982 763 A1

Printed by Xerox (UK) Business Services
2.16.7/3.6

**Description**

The present invention relates generally to a process for forming a compound semiconductor layer by the vapor phase growth of a thin film form of compound semiconductor starting from a hydride and an organic metal, and more particularly to a process for the fabrication of a compound semiconductor that lends itself well fit both for the flattening of the grown layer and for inhibiting deposition of polycrystals on a protective film for selective growth.

In order to improve the performance of compound semiconductor elements, quantum-effect devices and devices making use of two dimensional electron gases are now under vigorous development. For the fabrication of these devices, it is required to place growth rates under precise control, and this is usually achieved by using molecular beam epitaxial (MBE) and metal organic vapor phase epitaxial (MOVPE) growth techniques. Indeed, these epitaxial growth techniques are used to form heterojunction interfaces that are sharp at an atomic layer level. When these structures are applied to elements, the element properties are largely affected by the flatness of the heterojunction interfaces. For instance, an Al-containing compound interface is unsatisfactory in terms of flatness, because the migration length of the Al-containing compound molecules is short, offering some problems such as an electron mobility drop. In recent years, selective growth has been used to achieve an optimal device structure. However, since much difficulty is involved in achieving the selective growth by the MBE technique, the MOVPE technique is usually employed to this end. The selective growth process has a great advantage that a selective growth region of high quality and hence a high-performance element can be obtained, partly because it causes no damage to material and partly because it takes place at a relative low temperature.

However, the selective growth process is subject to some considerable restriction in terms of growth conditions, mole fraction , mask width, etc., for inhibiting deposition polycrystal on a protective film.

Especially in the case of an Al-containing compound, the higher the composition of Al and the larger the mask width, the more likely is the deposition of polycrystals on the protective film. This offers a problem that any desired device structure is unachievable.

An object of the present invention is to provide a process for the fabrication of a semiconductor having the heterojunction interface improved in terms of flatness and providing device with excellent properties.

DISCLOSURE OF THE INVENTION

The inventors have made intensive and far-reaching investigations so as to provide a solution to the problems mentioned above, and have consequently accomplished the present invention on the basis of the finding that when forming the heterostructure of a compound semiconductor or attaining the selective growth of crystals, a halide gas and/or a halogen gas free from the mother elements of the compound to be grown is added to the reaction atmosphere, thereby making it possible to flatten the surface of the grown layer or attain the growth of high-quality crystals without deposition of polycrystals on a mask over a wide region. More specifically, the present invention provides a vapor phase growth process for fabricating a thin film of compound semiconductor by the use of a halogen element-free hydride and a halogen element-free organic metal as the source materials, said process being characterized in that a halide gas and/or a halogen gas that are free from the mother elements of the compound to be grown are added to the reaction atmosphere during the growth.

For the source materials for compound semiconductors used in the fabrication process of the invention, any desired materials may be used, with the proviso that they are ordinarily used hydrides and organic metals, all being free from halogen elements. In the invention, the halogen element-free hydrides used are generally arsine ($AsH_3$), phosphine ($PH_3$), and so on, and the halogen element-free organic metals used are generally trimethylgallium (TMG), triethylgallium (TEG), trimethylaluminum (TMA), trimethylindium (TMI), and so on.

In the invention, the halogen element-free source materials are used, as mentioned above, and this is because the use of halogenides of Group III or V such as gallium chloride (GaCl), diethylgallium chloride (DEGaCl), and arsenic trichloride ($AsCl_3$) makes growth mechanism complicated, renders precise growth rate control difficult, causes a quartz tube to be subject to a corrosive attack in the case of the growth of Al-containing compounds, or offers other problems.

For the halide gas and/or halogen gas that are free from the mother elements of the compound to be grown, by way of example but not by way of limitation, use may be made of HBr, HI, HF, HCl, and $CCl_2F_2$ (for the halide gas) and $Cl_2$, $I_2$, $F_2$, and $Br_2$ or their mixtures (for the halogen gas). Notice that preference is given to HCl.

The quantity of the halide gas and/or halogen gas used, that are free from the mother elements of the compound to be grown, may vary largely depending on growth chamber size, growth temperature, etc., and may usually be smaller than the quantities of the halogen element-free organic metal.

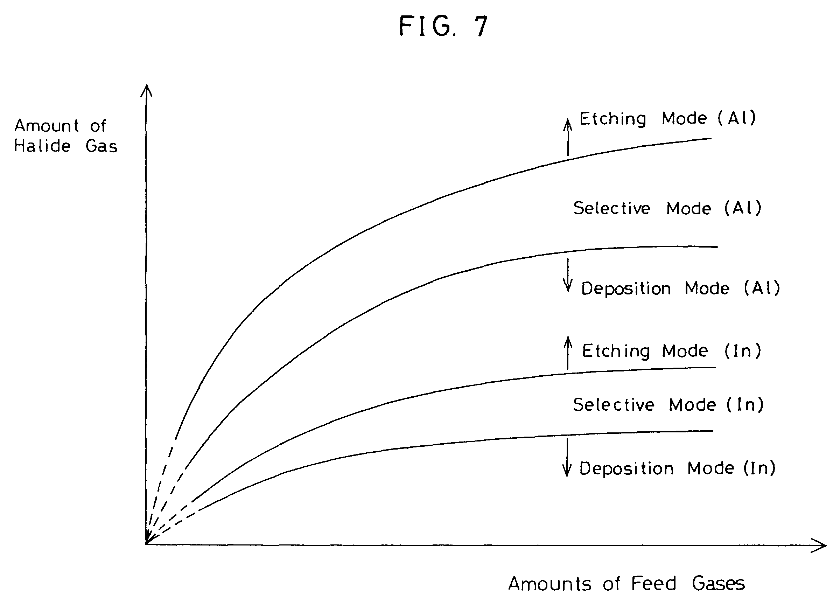

The quantitative relation between both the gases is then determined such that a selective mode wherein crystal growth takes place but no polycrystal is deposited on a mask, rather than an etching mode wherein no growth takes place and instead etching goes on and a deposition mode wherein polycrystals are deposited on a mask, is well established. Fig. 7 presents an illustration of how this is achieved in the case of aluminum and indium. Specific values of these quantities differ depending on growth chamber size, temperature, the source materials used, etc., as already noted, but those skilled in the art will be able to determine them optimally, with the equipment used in mind. It is here noted that low temperatures result in an etching rate reduction; in other words, at a low temperature, it is preferable to use the halide gas and/or halogen gas - that are free from the mother elements of the compound to be grown - in an increased amount.

Preferably, the total pressure of the gases fed in is at normal pressure or lower.

Growth temperature is not critical, if it lies within the temperature ranges ordinarily used for general vapor phase growth processes, and may generally lies within the range of about 500 to 800°C, preferably about 600 to 800°C.

The fabrication process of the invention is effective for the growth of thin semiconductor films of Group III - V compounds , and particularly favorable for the growth of thin semiconductor films of Al-containing Group III - V compounds . More illustratively, the present fabrication process is well suited to the growth of AlInGaP, InAlAs, and AlInP, inter alia, AlGaAs. For the aluminum-containing starting gas, various well-known materials may be used. However, preference is given to using trialkylaluminum, because its reaction is relatively simple in mechanism, it decomposes to produce a gas with a plain behavior, and it is relatively inexpensive. Here, too, preference is given to using HCl as the halide gas and/or halogen gas. Preferably, the amounts of the trialkylaluminum and HCl fed into and used in a growth chamber are such chosen as to permit the molar (HCl/trialkylaluminum) ratio, R, to be 100 or lower. R exceeding 100 is not preferable, because it gives rise to some considerable growth rate reduction and, in some cases, may possibly cause the selective mode to pass into the etching mode. When the thin films of Al-containing Group III - V compounds are doped, it is preferable that the molar ratio R conforms to the following formula :

$$\left.\begin{array}{l} \text{when } 0 < X_{Al} \leq 0.2, \ R \leq 100 \\[6pt] \text{when } 0.2 < X_{Al} \leq 0.4, \ R \leq 50 \\[18pt] \text{when } 0.4 < X_{Al} \leq 1, \ R \leq 10 \end{array}\right\} (I)$$

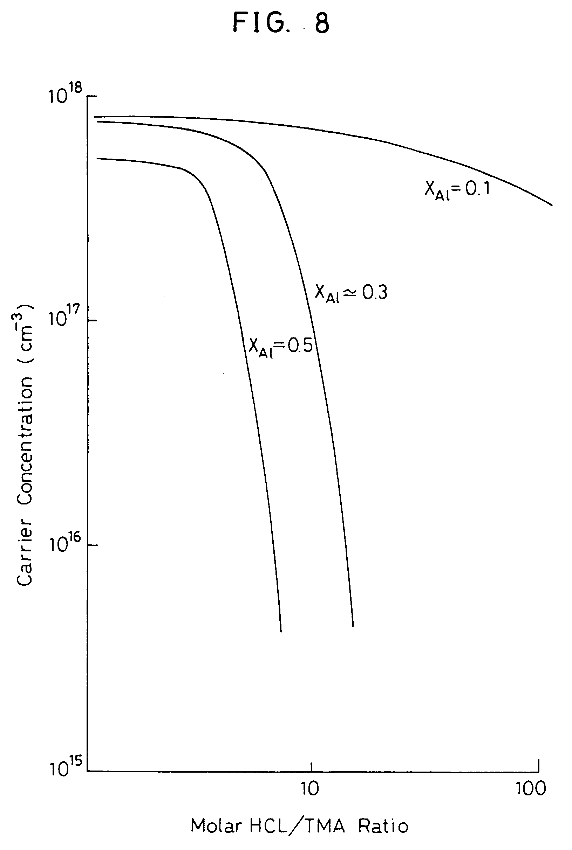

A departure of R from the range defined by Formulae I - that corresponds to the aluminium molar ratio $X_{Al}$ in the elements of Group III in the compounds of the elements of Groups III-V - is not preferable, because the carriers introduced by doping are likely to be inactivated. Fig. 8 represents the correlation between the molar ratio R and the carrier concentration when triethylaluminum and HCl were respectively used as the trialkylaluminum and the halide gas and/or halogen gas. Fig. 8, plotted on the basis of results of Example 3, teaches that the carrier concentration is largely affected by the molar ratio, $X_{Al}$.

Various well-known types of dopants may be used for the doping of the thin films of Group III - V compounds according to the invention. The dopants, if they are incorporated in the side of Group III, help the present invention produce its own effect greatly, and this is particularly true of silicon and zinc. The effect of the present invention is particularly favorable for fabricating thin semiconductor films of Al-containing Group III - V compounds using silicon and zinc as the dopants.

According to the invention, a trace amount(s) of the halide gas and/or halogen gas - that are free from the mother elements of the compound to be grown - such as HCl is added to the reaction atmosphere during the growth. This enables the compound to be grown under conditions almost similar to those for conventional MOVPE techniques, making it possible to flatten the surface of the crystal film, improve surface morphology or the facets in terms of surface flatness, or effect the growth of high-quality crystals without deposition of polycrystals on a mask over a wide range.

BRIEF DESCRIPTION OF THE DRAWINGS

Figure 1 is an illustration of the heterostructure used in Example 1,
Figure 2 represents the full width at the half maximum of the PL spectra of the products obtained by the fabrication process of the invention and a conventional process,
Figure 3 represents a SiNx film stripe pattern on the GaAs substrate used in Example 2,
Figure 4 shows one example of the surface photomicrograph after selective growth according to a conventional process,
Figure 5 shows one example of the surface microphotograph. after selective growth according to the process of the invention,

Figure 6 shows another example of the surface microphotograph. structure after selective growth according to the process of the invention,

Figure 7 illustrates the quantity of the halide gas and/or halogen gas used in the invention and the quantity of the halide element-free, feed gases used in the invention,

Figure 8 illustrates the correlation between the molar ratio, R, of hydrogen chloride to triethylaluminium and the carrier concentration, found in Example 3, per molar aluminum ratio, $X_{Al}$, in the Group III elements in the Al-containing. Group III - V compounds.

## BEST MODE FOR CARRYING OUT THE INVENTION

In the following description, the present invention will be explained with reference to some examples. It is understood, however, that the invention is not limited to them insofar as it does not depart from the purport.

## Example 1

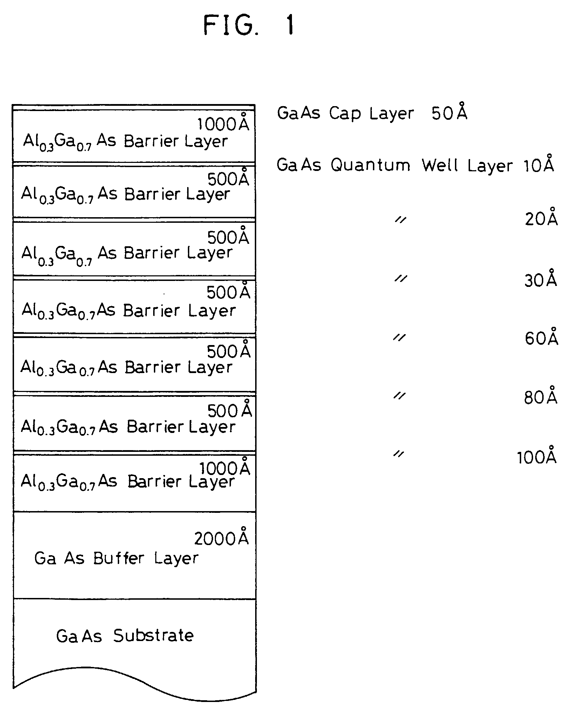

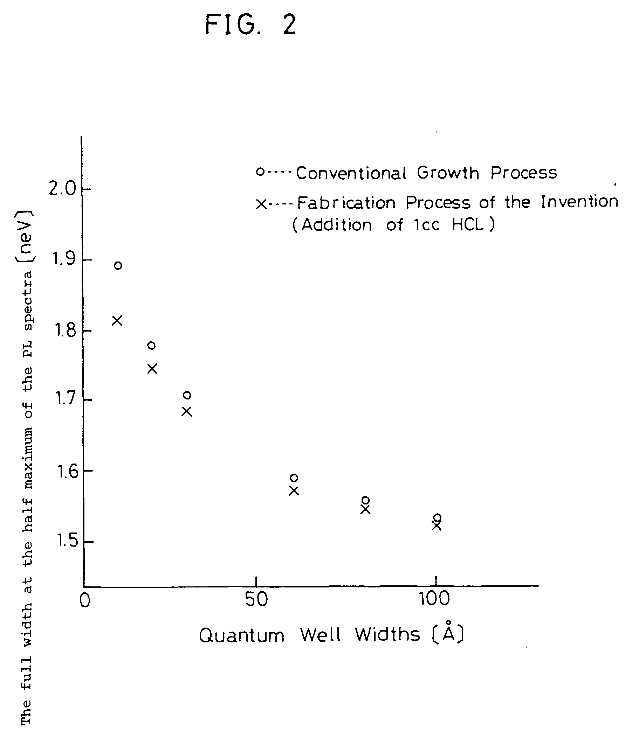

The MOVPE technique was used to fabricate a hetero-structure including on a Cr-doped GaAs {100} substrate $Al_{0.3}Ga_{0.7}As$ barrier layers and six GaAs quantum wells having well widths of 10 Å, 20 Å, 30 Å, 60 Å, 80Å and 100 Å, as illustrated in Fig. 1. The then used feed gases were trimethylgallium (TMG), trimethylaluminum (TMA) and arsine ($AsH_3$). The molar flow rates of TMG and TMA were $4.2 \times 10^{-5}$ mol/min and $8.4 \times 10^{-6}$ mol/min respectively, and the flow rate of 10% $AsH_3$ (diluted with $H_2$) was 800 sccm (standard cubic cm minute). The total flow rate was 7.7 SLM (standard litter minute), the growth temperature 650°C, the pressure 76 Torr and the growth rate about 1 μm/h. Under the above growth conditions, 1 cc of HCl was added to the reaction atmosphere during the growth of the $Al_{0.3}Ga_{0.7}As$ barrier layers to prepare Sample (A), and Sample (B) was prepared according to a conventional process making no use of HCl. Under the above growth conditions, the addition of 1 cc of HCl gave rise to a growth rate reduction, but this was barely 2%. These samples were measured at 4.2 K in terms of photoluminescence (PL) to observe light emissions from the quantum wells. The results of Samples (A) and (B) about PL measurement are shown in Fig. 2.

Both Samples (A) and (B) had an almost identical PL strength, but Sample (A) was much smaller in the full width at the half maximum of PL spectra than Sample (B). The full width at the half maximum of PL spectra has a close relation to the flatness of the heterojunction interface at both ends of the quantum wells; in other words, the flatter the heterojunction interface, the smaller the full width at the half maximum of PL spectra is. From this, it is presumed that the migration of the Al-containing compound is enhanced by the addition of HCl, contributing to making the heterojunction interface much flatter.

## Example 2

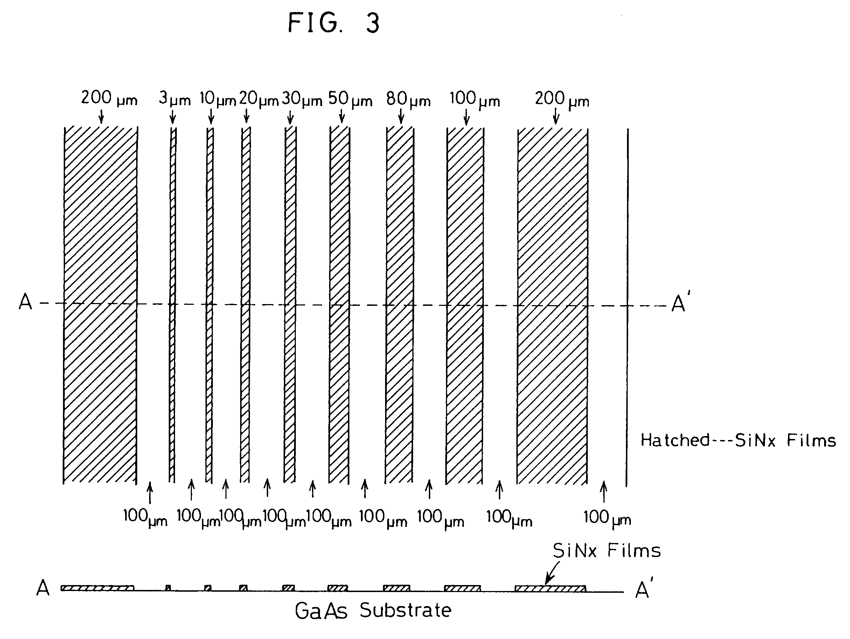

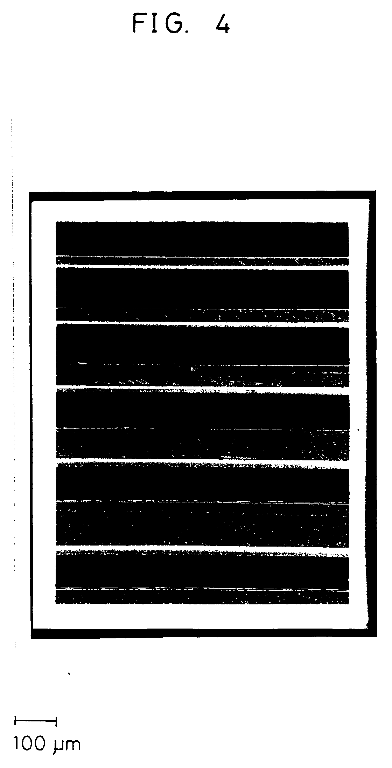

A GaAs substrate was provided thereon with a stripe pattern made up of SiNx films arranged at varying widths (3 μm to 200 μm) every 100 μm, as shown in Fig. 3, and an $Al_{0.5}Ga_{0.5}As$ layer or an AlAs layer, each of about 1 μm in thickness, was grown on the substrate by the MOVPE technique. The then used feed gases were trimethylgallium (TMG), trimethylaluminum (TMA) and arsine ($AsH_3$). The numbers of moles of TMG and TMA fed were 4.8 to $9.6 \times 10^{-5}$ mol/min and 1.8 to $3.6 \times 10^{-5}$ mol/min respectively, and the flow rate of $AsH_3$ (diluted with 10% $H_2$) was 800 sccm. The total flow rate was 7.7 SLM, the growth temperature 750°C, the pressure 76 Torr and the growth rate about 2 μm/h. Under the above growth conditions, 1 cc of HCl was added to the reaction atmosphere during the growth to prepare Sample (C), and Sample (D) was prepared according to a conventional growth process making no use of HCl. Optical micrographs taken of the surfaces of the wafers after the growth are presented in the form of Figs. 4 (Sample (D)) and 5 (Sample (C)). Under the above growth conditions, a growth rate reduction by the addition of 1cc of HCl was 5%. As can be seen from Fig. 4, a thick layer of polycrystal deposits is built up even over the rarrow SiNx film stripe (of 3 mm in width) of Sample (D) having the $Al_{0.5}Ga_{0.5}As$ layer grown thereon. It has been reported about conventional MOVPE techniques that some considerable difficulty is involved in the selective growth of an Al composition having an Al content of 0.35 or more, even when it is carried out at a reduced pressure of a few tens Torr, because the migration length of the Al-containing compound is considerably short. This, too, holds well for Sample (D) prepared by a conventional process.

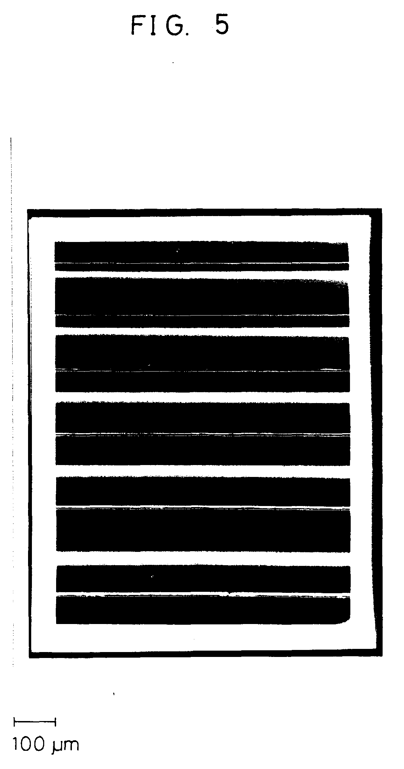

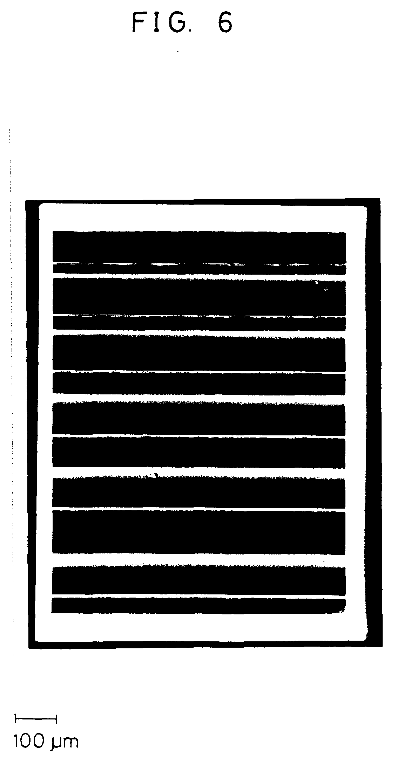

In the case of Sample (C) prepared by the fabrication process of the invention with the $Al_{0.5}Ga_{0.5}As$ layer formed thereon, on the other hand, no polycrystal deposition is found even over the 200-μm-wide SiNx film stripe, as can be seen from Fig. 5. In the case of another Sample (C) with the AlAs layer formed thereon, only a few polycrystals are scattered over the 80-μm-wide SiNx film stripe, as can be seen from Fig. 6. From this, it is presumed that the migration of the Al-containing compound is accelerated by the addition of HCl, enabling its selective growth to be well done.

Example 3

An about 1-μm-thick $Al_xGa_{1-x}A$ was grown on a (100) GaAs substrate at a varying Al proportion ($X_{Al}$) by MOVPE. The then used supplied gases were trimethylgallium (TMG), trimethylaluminum (TMA) and arsine ($ASH_3$). The molar flow rates of TMG and TMA were 4.8 to 9.6 x $10^{-5}$ mol/min and 1.8 to 3.6 x $10^{-5}$ mol/min respectively, and the flow rate of 10% $AsH_3$ (diluted with $H_2$) was 800 sccm. The dopant used was disilane ($Si_2H_6$), which was added to the reaction atmosphere such that the carrier concentration came under the range of 5.0-10.0 x $10^{17}$ $cm^{-3}$ in the absence of HCl. The total flow rate was 7.7 SLM, the growth temperature 750°C, the growth pressure 76 Torr and the growth rate about 2 μm/h. During the growth, the HCl concentration was varied between 1 and 100 in terms of the molar flow rate ratio with respect to TMA. The results are shown in Fig. 8. At an Al composition of 0.1, there is no appreciable carrier concentration decrease, even when the HCl concentration is increased. At an Al proportion exceeding 0.3, however, the carrier concentration starts to decrease from when the molar flow rate ratio of HCl with respect to TMA exceeds 3.

On the other hand, a (100) GaAs substrate provided with a similar SiNx film stripe pattern as shown in Fig. 3 was subjected to the same growth process. In the absence of HCl, polycrystal deposits on the stripes were found, as the Al proportion increased. In the presence of HCl, however, no deposition of polycrystals was found on the stripes.

INDUSTRIAL APPLICABILITY

According to the invention, a trace amount(s) of a halide gas and/or a halogen gas free from the mother elements of the compound to be grown is added to the reaction atmosphere while a compound semiconductor is growing, as detailed above, thereby making it possible to flatten the heterojunction interface, or to effect the growth of high-quality crystals without deposition of polycrystals on the mask used over a wide range. A few % growth rate decrease occurs by the addition of a trace amount of HCl, but the reproducibility and controllability of conventional MOVPE remain almost intact, providing an effective procedure for industrial exploitation.

**Claims**

1.    A process for forming a quantum well heterostructure by vapor-phase growth of a III-V compound semiconductor thin film using a halogen element-free hydride and a halogen element-free organometallic compound as raw materials to be grown, wherein the III-V compound semiconductor thin film is grown while a halide gas and/or a halogen gas free from mother elements of the compounds to be grown is added to a reaction atmosphere.

2.    A process according to claim 1, characterized in that the quantum well heterostructure comprises two barrier layers and a quantum well layer sandwiched therebetween.

3.    A process according to claim 1 or 2, characterized by growth of an aluminum-containing III-V compound semiconductor thin film.

4.    A process according to claim 3, characterized by use of an aluminum-containing organometallic compound.

5.    A process according to claim 4, characterized in that the aluminum-containing organometallic compound is a trialkylaluminum and the halide gas is a hydrogen chloride gas, with a growth temperature of 500 to 800°C.

6.    A process according to claim 5, characterized in that a molar ratio R of the hydrogen chloride gas and the trialkylaluminum is in the range of R ≤ 100.

7.    A process according to claim 6, characterized in that the molar ratio R of the hydrogen chloride gas to the trialkylaluminum and the molar ratio $X_{Al}$ of aluminum in the elements of group III of the aluminum-containing III-V compound satisfy the following relations:

    $0 < R \leq 100$, when $0 < X_{Al} \leq 0.2$
    $0 < R \leq 50$, when $0.2 < X_{Al} \leq 0.4$
    $0 < R \leq 10$, when $0.4 < X_{Al} \leq 1$

8.    A process according to any one of claims 1 to 7, characterized in that the growth rate of said semiconductor thin film is decreased when compared with a process where the halide gas and/or the halogen gas are not added to said reaction atmosphere.

# FIG. 1

| | |
|---|---|
| 1000Å $Al_{0.3}Ga_{0.7}$ As Barrier Layer | |
| 500Å $Al_{0.3}Ga_{0.7}$ As Barrier Layer | |
| 500Å $Al_{0.3}Ga_{0.7}$ As Barrier Layer | |
| 500Å $Al_{0.3}Ga_{0.7}$As Barrier Layer | |
| 500Å $Al_{0.3}Ga_{0.7}$As Barrier Layer | |
| 500Å $Al_{0.3}Ga_{0.7}$As Barrier Layer | |
| 1000Å $Al_{0.3}Ga_{0.7}$As Barrier Layer | |
| 2000Å Ga As Buffer Layer | |
| Ga As Substrate | |

GaAs Cap Layer 50Å

GaAs Quantum Well Layer 10Å

〃 20Å

〃 30Å

〃 60Å

〃 80Å

〃 100Å

# FIG. 2

o----Conventional Growth Process

x----Fabrication Process of the Invention
(Addition of 1cc HCL)

# FIG. 3

Hatched---SiNx Films

SiNx Films

GaAs Substrate

# FIG. 4

100 μm

# FIG. 5

100 μm

# FIG. 6

├────┤
100 µm

# FIG. 7

Amount of
Halide Gas

↑ Etching Mode ( Al )

Selective Mode ( Al )

↓ Deposition Mode ( Al )

↑ Etching Mode ( In )

Selective Mode ( In )

↓ Deposition Mode ( In )

Amounts of Feed Gases

EP 0 982 763 A1

# FIG. 8

**European Patent Office**

## EUROPEAN SEARCH REPORT

Application Number

EP 99 11 5133

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | STRINGFELLOW G B ET AL: "VPE growth of Al(x)Ga(1-x)As" JOURNAL OF CRYSTAL GROWTH, vol. 43, no. 1, 1978, pages 47-60, XP002123519 ISSN: 0022-0248 | 1,3-6,8 | H01L21/205 |
| A | * the whole document * | 2,7 | |
| X | US 4 147 571 A (STRINGFELLOW GERALD B ET AL) 3 April 1979 (1979-04-03) | 1,3-6 | |
| A | * the whole document * | 2,7 | |
| X | US 4 767 494 A (KOBAYASHI NAOKI ET AL) 30 August 1988 (1988-08-30) * figures 15,46; examples 4,9,16 * | 1-5 | |
| | | | TECHNICAL FIELDS SEARCHED (Int.Cl.6) |
| | | | H01L C30B H01S |

The present search report has been drawn up for all claims

| Place of search | Date of completion of the search | Examiner |
|---|---|---|
| THE HAGUE | 23 November 1999 | Köpf, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 99 11 5133

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-1999

| Patent document cited in search report | Publication date | Patent family member(s) | | Publication date |
|---|---|---|---|---|
| US 4147571 A | 03-04-1979 | DE | 2830081 A | 01-02-1979 |
| | | GB | 1593905 A | 22-07-1981 |
| | | JP | 54039387 A | 26-03-1979 |
| US 4767494 A | 30-08-1988 | JP | 1974201 C | 27-09-1995 |
| | | JP | 7008756 B | 01-02-1995 |
| | | JP | 63017293 A | 25-01-1988 |
| | | JP | 7008757 B | 01-02-1995 |
| | | JP | 63035494 A | 16-02-1988 |
| | | FR | 2604296 A | 25-03-1988 |
| | | GB | 2192198 A,B | 06-01-1988 |

EPO FORM P0459

For more details about this annex : see Official Journal of the European Patent Office, No. 12/82